# EUROPÄISCHE PATENTSCHRIFT

(11) **EP 3 549 414 B1**
(45) Veröffentlichungstag und Bekanntmachung des Hinweises auf die Patenterteilung: **12.08.2020**
(21) Anmeldenummer: 17764542.1
(22) Anmeldetag: 05.09.2017
(51) Int. Cl.: H05K 5/00

(54) **ELEKTRISCHE BAUGRUPPE**
ELECTRICAL ASSEMBLY
ENSEMBLE ÉLECTRIQUE

(30) Priorität: 02.12.2016 DE 102016224083
(43) Veröffentlichungstag der Anmeldung: 09.10.2019
(73) Patentinhaber: Robert Bosch GmbH, 70442 Stuttgart (DE)
(72) Erfinder: MOELLER, Stefan, 99869 Friedrichswerth (DE)
(86) Internationale Anmeldenummer: PCT/EP2017/072188
(87) Internationale Veröffentlichungsnummer: WO 2018/099620

(56) Entgegenhaltungen:
- WO-A1-2014/054145
- WO-A1-2015/029629

## Beschreibung

### Stand der Technik

Elektronische Getriebesteuermodule werden zur Ansteuerung am oder im Getriebe verbaut und können dem aggressiven Getriebefluid ausgesetzt sein. Die Getriebesteuermodule weisen elektrische Baugruppen auf, die vor dem Getriebefluid geschützt werden müssen. Die elektrischen Baugruppen können ein Leiterplattensubstrat als Schaltungsträger aufweisen, auf dem elektrische Bauelemente bestückt sind, die über Leiterbahnen des Leiterplattensubstrats elektrisch kontaktiert werden. Neben metallischen Deckelteilen, die zum Schutz über den elektrischen Bauelementen auf dem Leiterplattensubstrat angeordnet werden, ist es auch bekannt, ein auf das Leiterplattensubstrat aufgetragenes Umhüllungsmaterial zum Schutz der elektrischen Bauelemente zu verwenden. Das Umhüllungsmaterial kann als Moldmasse in einem Ummoldungsverfahren oder als Vergussmasse über die zu schützenden elektrischen Bauelemente auf dem Leiterplattensubstrat aufgetragen werden.

Aus der DE 10 2015 205 054 A1 ist ein Elektronikmodul für eine Getriebesteuereinheit bekannt, bei dem das Elektronikmodul ein Leiterplattensubstrat aufweist, auf dem wenigstens ein ungehäustes Halbleiterbauelement angeordnet ist. Zum Schutz des ungehäusten Halbleiterbauelementes vor ionisierender Strahlung ist über dem Halbleiterbauelement eine Schutzkappe auf dem Leiterplattensubstrat angeordnet. Die Schutzkappe ist mit einem auf das Leiterplattensubstrat (und auf weitere außerhalb der Schutzkappe angeordnete elektrische Bauelemente) aufgetragenen Umhüllungsmaterial aus beispielsweise Duroplast vollständig bedeckt.

Aus der WO 2015/029629 A1 und der WO 2014/054145 A1 sind elektrische Baugruppen mit einem Leiterplattensubstraten und einer Schutzkappe bekannt, bei denen ein Umhüllungsmaterial über der Schutzkappe aufgetragen ist.

### Offenbarung der Erfindung

Die Erfindung betrifft eine elektrische Baugruppe, insbesondere zur Verwendung in einem Hydraulikfluid eines Kraftfahrzeuggetriebes, welche ein Leiterplattensubstrat und wenigstens ein auf dem Leiterplattensubstrat angeordnetes und mit dem Leiterplattensubstrat elektrisch kontaktiertes elektrisches Bauelement umfasst. Über dem elektrischen Bauelement ist eine Schutzkappe angeordnet. Ein auf das Leiterplattensubstrat über der Schutzkappe aufgetragenes Umhüllungsmaterial bedeckt zumindest die Schutzkappe. Erfindungsgemäß ist vorgesehen, dass die Schutzkappe mit wenigstens einer Einfüllöffnung versehen ist und dass das Umhüllungsmaterial durch die wenigstens eine Einfüllöffnung in einen Kappeninnenraum zwischen der Schutzkappe und dem Leiterplattensubstrat derart eingebracht ist, dass zwischen der Schutzkappe und dem elektrischen Bauelement ein nicht mit dem Umhüllungsmaterial gefüllter Freiraum verbleibt, der direkt an das wenigstens eine elektrische Bauelement angrenzt.

Die elektrische Baugruppe kann ein Teil eines elektronischen Getriebesteuermoduls sein oder ein elektronisches Getriebesteuermodul umfassen, ohne darauf beschränkt zu sein. Die elektrische Baugruppe kann auch Teil eines Sensormoduls sein oder ein Sensormodul umfassen. Die elektrische Baugruppe kann im oder am Kraftfahrzeuggetriebe verbaut werden. Jedoch sind auch andere Verwendungen denkbar.

Unter einem Leiterplattensubstrat wird ein Trägersubstrat von elektrischen Bauelementen verstanden, welches Leiterbahnen für den Anschluss der elektrischen Bauelemente an eine Steuerschaltung oder zur Kontaktierung der elektrischen Bauelemente untereinander aufweist. Ein Leiterplattensubstrat kann insbesondere eine starre Leiterplatte aus glasfaserverstärktem Epoxidharz (FR4 oder höherwertig), ein keramisches Trägersubstrat (beispielsweise eine Hybridschaltung) oder eine flexible Leiterfolie sein.

Unter einem Umhüllungsmaterial wird eine im Urzustand fließfähige und eine während oder nach der Auftragung ausgehärtete Schutzmasse verstanden. Vorzugsweise handelt es sich um ein Duroplast, insbesondere ein Epoxidharz. Das Umhüllungsmaterial kann beispielsweise durch ein Transfer-Moldverfahren, ein Kompressions-Moldverfahren, Duroplastspritzverfahren oder ein Vergußverfahren auf das Leiterplattensubstrat aufgetragen sein.

### Vorteile der Erfindung

Die erfindungsgemäße elektrische Baugruppe bildet vorteilhaft einen Schutz für das wenigstens eine elektrische Bauelement während des Auftragens des Umhüllungsmaterials vor den dabei entstehenden thermischen und/oder mechanischen Belastungen. Dies ist besonders vorteilhaft, um beispielsweise die großen becherförmigen Gehäuse von Elektrolytkondensatoren vor einer Beschädigung durch Druckspitzen beim Duroplastspritzen oder Transfermolden zu schützen. Durch die Schutzkappe werden Belastungen auf das Bauelement reduziert. Dadurch, dass die Schutzkappe mit wenigstens einer Einfüllöffnung versehen ist und das Umhüllungsmaterial durch die wenigstens eine Einfüllöffnung in einen Kappeninnenraum zwischen der Schutzkappe und dem Leiterplattensubstrat teilweise eingebracht ist, wird ein Schutz der elektrischen Anschlüsse des Bauelementes erreicht und vermieden, dass sich zu große Lufträume unter dem Umhüllungsmaterial befinden, die im Betrieb durch Temperaturschwankungen oder Druckschwankungen zu einer Rissbildung in dem Umhüllungsmaterial führen könnten. Außerdem stabilisiert das Umhüllungsmaterial das wenigstens eine elektrische Bauelemente gegenüber Stoß- und/oder Vibrationsbelastungen und entlastet somit die elektrischen Anschlüsse desselben.

Zwischen der Schutzkappe und dem Leiterplattensubstrat verbleibt nur ein kleiner nicht mit dem Umhüllungsmaterial gefüllter Freiraum (Kavität), der direkt an das wenigstens eine elektrische Bauelement angrenzt. Dieser Freiraum bildet vorteilhaft einen Ausgleichsraum, in den sich das elektrische Bauelement oder Teile des elektrischen Bauelementes teilweise ausdehnen können. Der Freiraum kann mit Luft oder einem anderen Gas gefüllt sein. Der Freiraum bildet beispielsweise einen Aufnahmeraum, welcher im unwahrscheinlichen Fall des Ausgasens oder des Berstens eines Elektrolytkondensators die austretenden Gase oder Säuren aufnehmen kann, ohne dass das Umhüllungsmaterial aufbrechen kann. Die übrigen elektrischen Bauelemente auf dem Leiterplattensubstrat und die elektronische Schaltung sind daher auch bei einem Defekt eines einzelnen elektrischen Bauelementes weiterhin gegen das aggressive Getriebefluid geschützt.

Die Schutzkappe weist eine das elektrische Bauelement umfangsseitig umgebende, senkrecht auf das Leiterplattensubstrat aufgesetzte Kappenwand und einen Deckelabschnitt auf der von dem Leiterplattensubstrat abgewandten Seite über dem elektrischen Bauelement auf, wobei die Einfüllöffnung im Übergangsbereich zwischen Deckelabschnitt und Kappenwand vorgesehen ist. Hierdurch wird ein einfacher Aufbau erreicht, bei dem die Kappenwand das elektrische Bauelement bezüglich aller parallel zur Leiterplattensubstrat einwirkenden Kraftvektoren schützt, während das Deckelteil einen Schutz der von dem Leiterplattensubstrat abgewandten Seite des elektrischen Bauelementes bewirkt. In den Übergangsbereich kann die Einfüllöffnung besonders leicht angeordnet werden.

Vorteilhaft ist weiterhin, dasss der Deckelabschnitt einen in den Kappeninnenraum vorspringenden Kragen aufweist. Der in den Kappeninnenraum vorspringenden Kragen des Deckelabschnitts kann das elektrische Bauelement vorteilhaft an seinem von dem Leiterplattensubstrat abgewandten Ende derart umfasst, dass zwischen dem Kragen und dem elektrischen Bauelement nur ein sehr schmaler Zwischenraum besteht, der mit dem Freiraum in Verbindung steht. Auf diese Weise kann sehr einfach erreicht werden, dass der Freiraum nicht vollständig mit dem Umhüllungsmaterial aufgefüllt wird.

Vorteilhafte Ausführungsformen und Weiterbildungen der Erfindung werden durch die in den abhängigen Ansprüchen angegebenen Merkmale ermöglicht.

Vorteilhaft ist wenigstens eine Einfüllöffnung der Schutzkappe mit dem Freiraum durch einen im Querschnitt senkrecht zu dem Leiterplattensubstrat gesehen labyrinthartige, insbesondere U-förmige Kanalstruktur verbunden. Durch die Kanalstruktur wird erreicht, dass das in den Kappeninnenraum eindringende Umhüllungsmaterial zunächst in Richtung der den Kappeninnenraum zugewandten Fläche des Leiterplattensubstrats vordringt und diese bedeckt und erst anschließend in dem Kappeninnenraum aufsteigt, ohne in den Freiraum einzudringen.

Vorteilhaft kann die wenigstens eine Einfüllöffnung als Drosselstelle ausgebildet sein, um Druckspritzen während der Auftragung des Umhüllungsmaterials zu dämpfen. Druckspitzen des in die Einfüllöffnung eindringende Umhüllungsmaterial können daher vorteilhaft nicht ungedämpft auf das elektrische Bauelement einwirken.

Besonders vorteilhaft ist eine Ausführungsform, bei der die Schutzkappe mehrere Kappeninnenräume aufweist, in denen jeweils ein elektrisches Bauelement angeordnet ist. Die Schutzkappe kann vorteilhaft als preisgünstiges Kunststoffbauteil für die elektrische Baugruppe hergestellt werden und preisgünstig und einfach auf dem Leiterplattensubstrat über den zu schützenden elektrischen Bauelementen montiert werden.

Ohne darauf beschränkt zu sein, ist die elektrische Baugruppe besonders vorteilhaft verwendbar für elektrische Bauelemente, die als Kondensator, insbesondere als Elektrolytkondensator vorgesehen sind.

### Kurze Beschreibung der Zeichnungen

Es zeigen:
Fig. 1 einen Querschnitt durch eine fertig hergestellte erfindungsgemäße elektrische Baugruppe,
Fig. 2 eine Draufsicht auf eine erfindungsgemäße elektrische Baugruppe ohne das Umhüllungsmaterial,
Fig. 3 bis 6 einzelne Schritte bei der Herstellung der elektrischen Baugruppe aus Fig. 1.

### Ausführungsformen der Erfindung

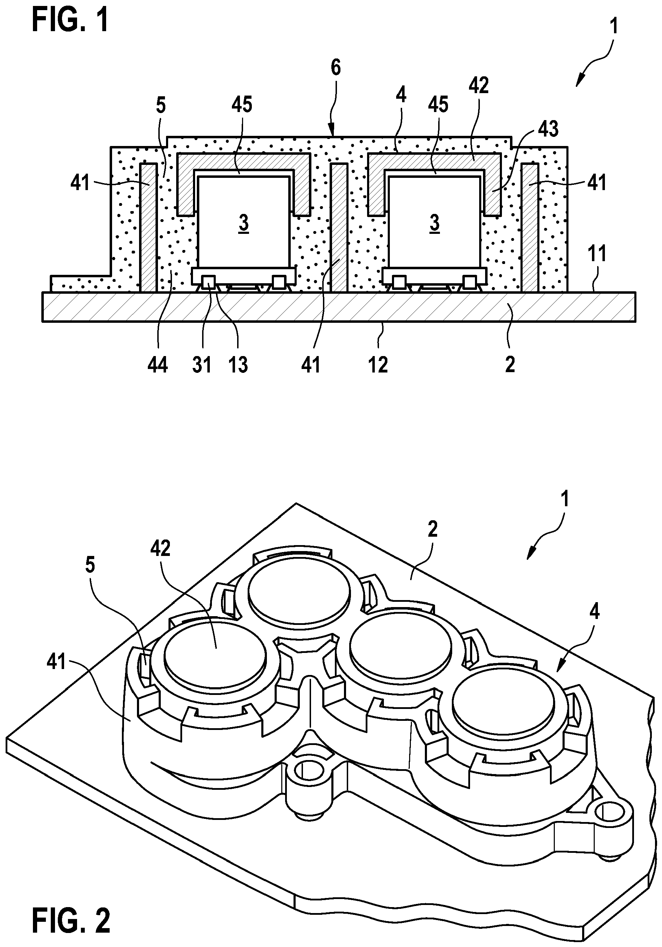

Fig. 1 zeigt einen Querschnitt durch eine fertige erfindungsgemäße elektrische Baugruppe 1. Dargestellt ist nur ein Teilausschnitt, der ein Leiterplattensubstrat 2 aufweist, das hier beispielhaft mit zwei elektrischen Bauelementen 3 bestückt ist. Bei den elektrischen Bauelementen 3 handelt es sich beispielsweise um Elektrolytkondensatoren, insbesondere um Polymer-Hybrid-Elkos. Die elektrischen Bauelemente 3 weisen auf ihrer Montageseite Anschlusselemente 31 auf, die mit Kontaktflächen 13 auf der Bestückungsseite 11 des Leiterplattensubstrats 2 durch beispielsweise Verlöten elektrisch kontaktiert sind. Die elektrischen Bauelemente 3 können eine im wesentlichen zylindrische Grundform mit zwei voneinander abgewandten Stirnseiten und einer im Querschnitt kreisförmigen Umfangswand aufweisen. Das Leiterplattensubstrat 2 kann eine Mehrlagenleiterplatte sein. Die Kontaktflächen 13 können über Leiterbahnen des Leiterplattensubstrats 2 mit einer nicht dargestellten Steuerschaltung verbunden sein, die auch auf dem Leiterplattensubtrat angeordnet sein kann (nicht dargestellt). Die elektrische Baugruppe 1 kann beispielsweise ein Teilbereich eines Getriebesteuermoduls oder ein Sensormodul sein.

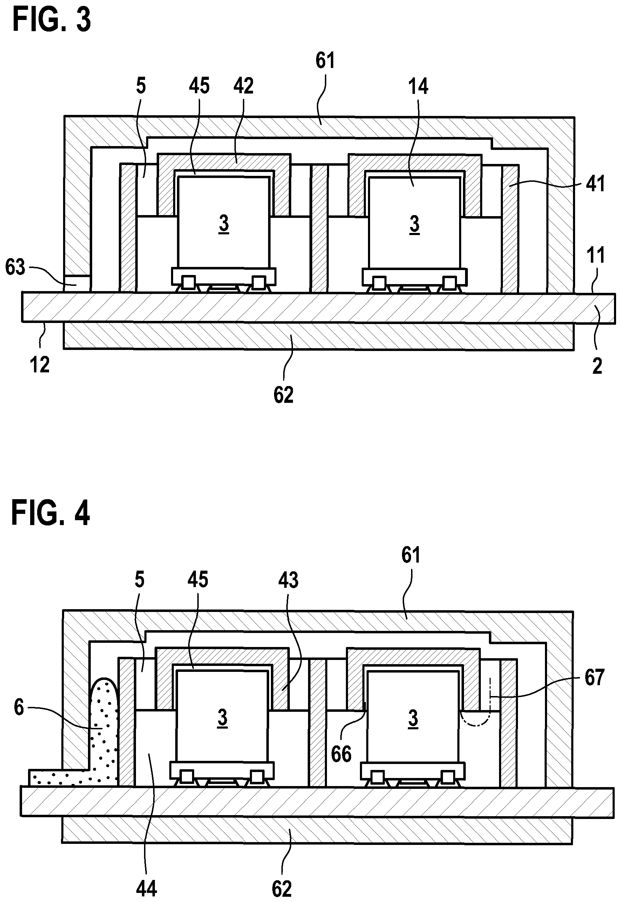

Wie in Fig. 1 dargestellt ist, ist eine Schutzkappe 4 auf dem Leiterplattensubstrat 2 angeordnet. Die Schutzkappe 4 kann aus Kunststoff oder Metall oder einem Kunststoff-Metall-Verbund bestehen und ist vorzugsweise einstückig ausgebildet. Die Schutzkappe 4 kann für jedes der elektrischen Bauelemente 3 einen diesem Bauelement 3 zugeordneten Kappeninnenraum 44 aufweisen. Der jeweilige Kappeninnenraum 3 wird begrenzt durch eine umlaufende Kappenwand 41 und einen Deckelabschnitt 42. Die Schutzkappe 4 wird derart auf die Bestückungsseite 11 des Leiterplattensubstrats senkrecht aufgesetzt, dass die Kappenwand 41 jedes der elektrischen Bauelemente 3 umfangsseitig umgibt und der jeweilige Deckelabschnitt 42 über der von dem Leiterplattensubstrat 2 abgewandten Seite des zugeordneten elektrischen Bauelements 3 abgeordnet ist. Im Übergangsbereich zwischen Deckelabschnitt 42 und der Kappenwand 41 ist pro Kappeninnenraum 44 jeweils wenigstens eine Einfüllöffnung 5 vorgesehen. In Querschnitt der Fig. 1 sind jedem Kappeninnenraum zwei Einfüllöffnungen 5 zugeordnet. Jeder Deckelabschnitt 42 weist einen in den Kappeninnenraum 44 vorspringenden Kragen 43 auf. Der in den Kappeninnenraum 44 vorspringenden Kragen 43 des Deckelabschnitts 42 umfasst das zugeordnete elektrische Bauelement 3 an seinem von dem Leiterplattensubstrat 2 abgewandten Ende 14 derart, dass zwischen dem Kragen 43 und dem elektrischen Bauelement 3 ein sehr schmaler Zwischenraum 66 besteht, der mit einem Freiraum 45 in Verbindung steht. Der Freiraum 45 befindet sich auf der von dem Leiterplattensubstrat 2 abgewandten Seite des elektrischen Bauelementes 3 zwischen dem Bauelement 3 und der Innenseite des Deckelabschnitts 42 und grenzt daher direkt an das elektrische Bauelement 3 an. Im Querschnitt senkrecht zu dem Leiterplattensubstrat 2 gesehen ist jede Einfüllöffnung 5 der Schutzkappe 4 mit dem zugeordneten Freiraum 45 durch eine labyrinthartige, insbesondere U-förmige Kanalstruktur 67 verbunden, wie durch die strichpunktierte Linie in Fig. 4 angedeutet ist.

Fig. 2 zeigt eine Außenansicht für ein weiteres Ausführungsbeispiel der Erfindung, ohne das aufgebrachte Umhüllungsmaterial. Man erkennt, dass die Schutzkappe 4 als Formteil mit einer umlaufenden Kappenwand 41, die auch Zwischenwände zwischen den vier Kappeninnenräumen 44 ausbildet, und mit beispielsweise vier Deckelabschnitten 42, die den jeweiligen elektrischen Bauelement zugeordnet sind, ausgebildet ist. Jedem Kappeninnenraum sind hier beispielsweise vier Einfüllöffnungen 5 zugeordnet.

Die Herstellung der elektrischen Baugruppe 1 ist in den Figuren 3 bis 6 dargestellt. Wie in Fig. 3 gezeigt ist, wird auf das mit den elektrischen Bauelementen 3 versehende Leiterplattensubstrat 2 zunächst de Schutzkappe 4 derart aufgesetzt, dass die Kappenwand 41 auf der Bestückungsseite 11 des Leiterplattensubstrats aufliegt und jedes elektrische Bauelement 3 in einem eigenen Kappeninnenraum 44 angeordnet ist. Die elektrische Baugruppe 1 wird sodann mitsamt der Schutzkappe 4 in eine Werkzeugform eingesetzt. Die Werkzeugform kann zweiteilig ausgebildet sein und weist eine auf die Bestückungsseite 11 des Leiterplattensubstrats 2 aufgesetzte erste Werkzeughälfte 61 und eine auf die Unterseite 12 des Leiterplattensubstrats 2 aufgesetzte zweite Werkzeughälfte 62 auf. Zwischen der Bestückungsseite 11 und der ersten Werkzeughälfte 61 ist eine Gusskanal 63 vorgesehen.

Wie in Fig. 4 zeigt ist wird ein fließfähige Umhüllungsmaterial 6 auf die Bestückungsseite 11 des Leiterplattensubstrats 2 appliziert. Das Umhüllungsmaterial 6 kann beispielsweise ein Duroplast, insbesondere ein Epoxidharz sein. Das Umhüllungsmaterial kann beispielsweise durch ein Transfer-Moldverfahren, ein Kompressions-Moldverfahren, Duroplastspritzverfahren oder ein Vergußverfahren auf das Leiterplattensubstrat aufgetragen sein. Dabei kann Druck aufgewandt werden, so dass das fließfähige Umhüllungsmaterial 6 in den Gusskanal 63 eindringt.

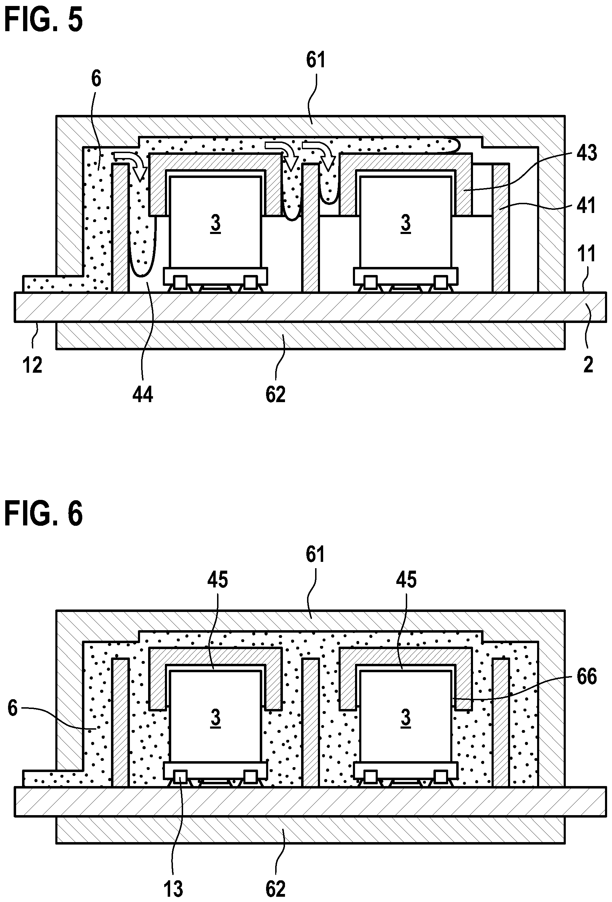

Wie in Fig. 5 dargestellt, steigt das fließfähige Umhüllungsmaterial 6 in dem Spalt zwischen der ersten Werkzeughälfte 61 und der Kappenwand 41 auf und fließt über die Deckelabschnitte 42. Wie durch die Pfeile in Fig. 5 angedeutet ist, dringt das Umhüllungsmaterial im Übergangsbereich von Kappenwand 41 und Deckelabschnitt 42 über die dort angeordneten Einfüllöffnungen 5 unter Einwirkung des aufgewandten Drucks und/oder der der Gravitation, welche in Fig. 5 von oben nach unten wirkt, in den Kappeninnenraum 44 ein. Die wenigstens eine Einfüllöffnung 5 wirkt dabei vorteilhaft als Drosselstelle und verhindert, dass Druckspritzen während des Einfüllvorgangs des Umhüllungsmaterials 6 ungedämpft auf das elektrische Bauelement 3 einwirken.

Das in den Kappeninnenraum 44 eindringende Umhüllungsmaterial 6 dringt zunächst in Richtung der dem Kappeninnenraum zugewandten Fläche 11 des Leiterplattensubstrats 2 vor und umfließt die elektrischen Anschlüsse 31 der elektrischen Bauelemente 2. Anschließend steigt das Umhüllungsmaterial 6, wie in Fig. 6 gezeigt ist, in dem Kappeninnenraum 44 bis an die Unterkante des Kragens 43 auf, dringt aber nicht durch den schmalen Spalt 66 in den Freiraum 45 ein. In dem Freiraum wird durch das Umhüllungsmaterial aus dem Kappeninnenraum verdrängte Luft komprimiert.

Nach der Herstellung der Umhüllung werden die Werkzeughälften 61, 62 entfernt, um das in Fig. 1 dargestellte fertige Endprodukt zu erhalten.

## Patentansprüche

1. Elektrische Baugruppe (1), insbesondere zur Verwendung in einem Hydraulikfluid eines Kraftfahrzeuggetriebes, umfassend ein Leiterplattensubstrat (2), wenigstens ein auf dem Leiterplattensubstrat (2) angeordnetes und mit dem Leiterplattensubstrat (2) elektrisch kontaktiertes elektrisches Bauelement (3), eine über dem elektrischen Bauelement (3) angeordnete Schutzkappe (4) und ein über der Schutzkappe (4) auf das Leiterplattensubstrat (2) aufgetragenes Umhüllungsmaterial (6), welches zumindest die Schutzkappe (4) von außen bedeckt, wobei die Schutzkappe (4) mit wenigstens einer Einfüllöffnung (5) versehen ist und das Umhüllungsmaterial (6) durch die wenigstens eine Einfüllöffnung (5) in einen Kappeninnenraum (44) zwischen der Schutzkappe (4) und dem Leiterplattensubstrat (2) derart eingebracht ist, dass zwischen der Schutzkappe (4) und dem Bauelement (3) ein nicht mit dem Umhüllungsmaterial (8) gefüllter Freiraum (45) verbleibt, der direkt an das wenigstens eine elektrische Bauelement (3) angrenzt, **dadurch gekennzeichnet, dass** die Schutzkappe (4) eine das elektrische Bauelement (3) umfangsseitig umgebende, senkrecht auf das Leiterplattensubstrat (2) aufgesetzte Kappenwand (41) und einen Deckelabschnitt (42) auf der von dem Leiterplattensubstrat (2) abgewandten Seite über dem elektrischen Bauelement (3) aufweist und die Einfüllöffnung (5) im Übergangsbereich zwischen Deckelabschnitt (42) und der Kappenwand (41) vorgesehen ist, dass der Deckelabschnitt (42) einen in den Kappeninnenraum (44) vorspringenden Kragen (43) aufweist und dass der in den Kappeninnenraum (44) vorspringenden Kragen (43) des Deckelabschnitts (42) das elektrische Bauelement (3) an seinem von dem Leiterplattensubstrat (2) abgewandten Ende (14) derart umfasst, dass zwischen dem Kragen (43) und dem elektrischen Bauelement (3) ein sehr schmaler Zwischenraum (66) besteht, der mit dem Freiraum (45) in Verbindung steht.

2. Elektrische Baugruppe nach Anspruch 1, **dadurch gekennzeichnet, dass** der nicht mit dem Umhüllungsmaterial (6) gefüllte Freiraum (45) einen Ausgleichsraum bildet, in den sich das elektrische Bauelement (3) oder Teile des elektrischen Bauelementes teilweise ausdehnen können.

3. Elektrische Baugruppe nach Anspruch 1, **dadurch gekennzeichnet, dass** die wenigstens eine Einfüllöffnung (5) der Schutzkappe (4) mit dem Freiraum (45) durch einen im Querschnitt senkrecht zu dem Leiterplattensubstrat (2) gesehen labyrinthartige, insbesondere U-förmige Kanalstruktur (67) verbunden ist.

4. Elektrische Baugruppe nach einem der vorstehenden Ansprüche, **dadurch gekennzeichnet, dass** die wenigstens eine Einfüllöffnung (5) als Drosselstelle ausgebildet ist, um Druckspritzen während des Einfüllvorgangs des Umhüllungsmaterials (6) zu dämpfen.

5. Elektrische Baugruppe nach Anspruch 1, **dadurch gekennzeichnet, dass** der Freiraum (45) mit einem Gas, insbesondere mit Luft gefüllt ist.

6. Elektrische Baugruppe nach einem der vorstehenden Ansprüche, **dadurch gekennzeichnet, dass** die Schutzkappe (4) mehrere Kappeninnenräume (45) aufweist, in denen jeweils ein elektrisches Bauelement (3) angeordnet ist.

7. Elektrische Baugruppe nach einem der vorstehenden Ansprüche, **dadurch gekennzeichnet, dass** das wenigstens eine elektrische Bauelement (3) ein Kondensator, insbesondere ein Elektrolytkondensator ist.

## Claims

1. Electrical assembly (1), in particular for use in a hydraulic fluid of a motor vehicle transmission, comprising a circuit board substrate (2), at least one electrical component (3) disposed on the circuit board substrate (2) and electrically connected to the circuit board substrate (2), a protective cap (4) placed over the electrical component (3) and an encapsulating material (6) applied to the circuit board substrate (2) over the protective cap (4), which at least covers the protective cap (4) from the outside, wherein the protective cap (4) is provided with at least one filling opening (5) and the encapsulating material (6) is introduced via the at least one filling opening (5) into an internal chamber (44) of the cap between the protective cap (4) and the circuit board substrate (2) in such a way that a free space (45) remains between the protective cap (4) and the component (3) that is not filled with the encapsulating material (8) and that directly adjoins the at least one electrical component (3), **characterized in that** the protective cap (4) comprises a cap wall (41) peripherally enveloping the electrical component (3) and placed perpendicularly on the circuit board substrate (2) and a cover section (42) on the side facing away from the circuit board substrate (2) and over the electrical component (3) and the filling opening (5) is provided in the transition region between the cover section (42) and the cap wall (41), **in that** the cover section (42) comprises a collar (43) protruding into the internal chamber (44) of the cap, and **in that** the collar (43) of the cover section (42) protruding into the internal chamber (44) of the cap includes the electrical component (3) at the end (14) thereof facing away from the circuit board substrate (2) in such a way that there is a very narrow space (66) between the collar (43) and the electrical component (3) that is connected to the free space (45).

2. Electrical assembly according to Claim 1, **characterized in that** the free space (45) that is not filled with the encapsulating material (6) forms a balancing chamber into which the electrical component (3) or parts of the electrical component can partially expand.

3. Electrical assembly according to Claim 1, **characterized in that** the at least one filling opening (5) of the protective cap (4) is connected to the free space (45) via a channel structure (67) that is labyrinthine, in particular U-shaped, when viewed in cross-section perpendicular to the circuit board substrate (2).

4. Electrical assembly according to one of the preceding claims, **characterized in that** the at least one filling opening (5) is formed as a throttle point to dampen pressure spikes during filling of the encapsulating material (6).

5. Electrical assembly according to Claim 1, **characterized in that** the free space (45) is filled with a gas, especially air.

6. Electrical assembly according to one of the preceding claims, **characterized in that** the protective cap (4) comprises several internal cap chambers (45), in each of which an electrical component (3) is disposed.

7. Electrical assembly according to one of the preceding claims, **characterized in that** the at least one electrical component (3) is a capacitor, especially an electrolytic capacitor.

## Revendications

1. Ensemble électrique (1), en particulier destiné à une utilisation dans un fluide hydraulique d'une boîte de vitesses de véhicule automobile, comprenant un substrat de carte de circuit imprimé (2), au moins un composant (3) électrique disposé sur le substrat de carte de circuit imprimé (2) et en contact électrique avec le substrat de carte de circuit imprimé (2), un couvercle de protection (4) disposé sur le composant électrique (3) et un matériau d'encapsulation (6) appliqué sur le substrat de carte de circuit imprimé (2) par-dessus le couvercle de protection (4), qui recouvre au moins le couvercle de protection (4) de l'extérieur, dans lequel le couvercle de protection (4) est pourvu d'au moins une ouverture de remplissage (5) et le matériau d'encapsulation (6) est introduit par l'intermédiaire de ladite au moins une ouverture de remplissage (5) dans un espace intérieur de couvercle (44) entre le couvercle de protection (4) et le substrat de carte de circuit imprimé (2) de telle manière qu'il reste entre le couvercle de protection (4) et le composant (3) un espace libre (45) non rempli par le matériau d'encapsulation (8), qui est directement adjacent audit au moins un composant électrique (3),
**caractérisé en ce que** le couvercle de protection (4) présente une paroi de couvercle (41) qui entoure le composant électrique (3) du côté de la circonférence et qui est placée perpendiculairement sur le substrat de carte de circuit imprimé (2), et une section de recouvrement (42) sur le côté tourné à l'opposé du substrat de carte de circuit imprimé (2), au-dessus du composant électrique (3), et l'ouverture de remplissage (5) est prévue dans la zone de transition entre la section de recouvrement (42) et la paroi de couvercle (41), **en ce que** la section de recouvrement (42) comporte un collier (43) faisant saillie dans l'espace intérieur de couvercle (44) et **en ce que** le collier (43) de la section de recouvrement (42) faisant saillie dans l'espace intérieur de couvercle (44) renferme le composant électrique (3) à son extrémité (14) tournée à l'opposé du substrat de carte de circuit imprimé (2) de telle manière qu'entre le collier (43) et le composant électrique (3), il existe un espace intermédiaire (66) très étroit, qui est relié à l'espace libre (45).

2. Ensemble électrique selon la revendication 1, **caractérisé en ce que** l'espace libre (45) non rempli par le matériau d'encapsulation (6) forme un espace de compensation dans lequel le composant électrique (3) ou des parties du composant électrique peuvent se dilater partiellement.

3. Ensemble électrique selon la revendication 1, **caractérisé en ce qu'**au moins une ouverture de remplissage (5) du couvercle de protection (4) est reliée à l'espace libre (45) par une structure de canal (67) qui, vue en coupe transversale perpendiculairement au substrat de carte de circuit imprimé (2), est en forme de labyrinthe, en particulier en forme de U.

4. Ensemble électrique selon l'une des revendications précédentes, **caractérisé en ce que** ladite au moins une ouverture de remplissage (5) est réalisée sous la forme d'un point d'étranglement afin d'amortir des projections sous pression pendant le processus de remplissage par le matériau d'encapsulation (6).

5. Ensemble électrique selon la revendication 1, **caractérisé en ce que** l'espace libre (45) est rempli par un gaz, en particulier par de l'air.

6. Ensemble électrique selon l'une des revendications précédentes, **caractérisé en ce que** le couvercle de protection (4) présente une pluralité d'espaces intérieurs de couvercle (45) dans chacun desquels est disposé un composant électrique (3).

7. Ensemble électrique selon l'une des revendications précédentes, **caractérisé en ce que** ledit au moins un composant électrique (3) est un condensateur, en particulier un condensateur électrolytique.
